# EUROPÄISCHE PATENTANMELDUNG

(11) **EP 2 437 294 A2**
(43) Veröffentlichungstag der Anmeldung: **04.04.2012**
(21) Anmeldenummer: 11176889.1
(22) Anmeldetag: 09.08.2011
(51) Int. Cl.: H01L 25/07

(54) **Leistungshalbleitermodul mit einem Grundmodul und einem Verbindungsmodul**

(30) Priorität: 01.10.2010 DE 102010041892
(71) Anmelder: Semikron Elektronik GmbH & Co. KG Patentabteilung, 90431 Nürnberg (DE)
(72) Erfinder: Stockmeier, Thomas, 90471 Nürnberg (DE); Göbl, Christian, 90441 Nürnberg (DE); Kroneder, Christian, 90596 Schwanstetten (DE)

(57) **Zusammenfassung**

Die Anmeldung betrifft ein Leistungshalbleitermodul mit einem elektrisch isolierenden Gehäuse, einem Grundmodul und einem Verbindungsmodul und ein zugeordnetes Verfahren zur dessen Herstellung, gekennzeichnet durch die folgenden Verfahrensschritte. Ausbilden von Halbleiterbaugruppen jeweils mit einem ersten Leitungselement mindestens einem hierauf angeordneten Leistungshalbleiterbauelement sowie einer ersten Kontakteinrichtung in elektrisch leitendem Kontakt zu dem ersten Leitungselement und einer zweiten Kontakteinrichtung in elektrisch leitendem Kontakt zu dem mindestens einen Leistungshalbleiterbauelement. Ausbilden des Grundmoduls durch elektrisch isoliertes Anordnen, mittels mindestens einer Isolationseinrichtung, der Halbleiterbaugruppen auf einer Grundplatte. Anordnen und schaltungsgerechtes Verbinden der mindestens einen Verbindungseinrichtung des Verbindungsmoduls mit zugeordneten Kontakteinrichtungen der Halbleiterbaugruppen.

## Beschreibung

Die Erfindung beschreibt ein Leistungshalbleitermodul mit einem elektrisch isolierenden Gehäuse und hierin angeordnet und schaltungsgerecht verbunden einer Mehrzahl von Leistungshalbleiterbauelementen.

Derartige Leistungshalbleitermodule sind beispielhaft aus der DE 10 2006 034 964 B3 bekannt. Diese offenbart ein Leistungshalbleitermodul mit zwei serielle geschalteten Leistungshalbleiterbauelementen, vorzugsweise als Thyristoren ausgebildet, die elektrisch isoliert auf einer Grundplatte angeordnet sind. Mittels zweier Anschlusselemente sind diese Leistungshalbleiterbauelemente mit externen Kontaktelementen verbunden. Ein Verbindungselement bildet einerseits die interne elektrische Verbindung der Leistungshalbleiterbauelemente aus und dient weiterhin als weiteres externes Kontaktelement. Die modulinternen Verbindungen der Kontaktelemente mit den Leistungshalbleiterbauelementen ist hierbei als kraftschlüssige Verbindungen ausgebildet und weisen hierzu je Leistungshalbleiterbauelement eine eigene Druckeinrichtung auf.

Nachteilig an einem derartigen Leistungshalbleiterbauelement ist das aufwändige Herstellungsverfahren, bei dem eine Vielzahl von einzelnen Komponenten nacheinander zu dem Leistungshalbleitermodul verbunden werden muss.

Der Erfindung liegt die Aufgabe zugrunde ein modular aufgebautes Leistungshalbleitermodul und ein zugehöriges vereinfachtes Herstellungsverfahren vorzustellen, wobei vorgefertigte Module zueinander angeordnet werden können und zusätzlich die verschiede interne Schaltungsvarianten eines Leistungshalbleitermoduls einfach realisierbar sind.

Die Aufgabe wird erfindungsgemäß gelöst, durch ein Leistungshalbleitermodul gemäß Anspruchs 1, sowie durch ein Verfahren mit den Merkmalen des Anspruch 5. Bevorzugte Ausführungsformen sind in den jeweiligen abhängigen Ansprüchen beschrieben.

Den Ausgangspunkt der Erfindung bildet ein Leistungshalbleitermodul mit einem elektrisch isolierenden Gehäuse, einer Grundplatte und externen Kontaktelementen zur schaltungsgerechten externen Verbindung der Leistungshalbleiterbauelemente des Leistungshalbleitermoduls. Das erfindungsgemäße Leistungshalbleitermodul weist hierbei neben dem Gehäuse zwei wesentliche Teilmodule, nämlich ein Grundmodul und ein Verbindungsmodul auf, wobei das Grundmodul seinerseits als wesentliche Komponenten mindestens zwei Halbleiterbaugruppen aufweist. Das zugehörige erfindungsgemäße Herstellungsverfahren für ein Leistungshalbleitermodul wird im Folgenden gemeinsam mit dem Leistungshalbleitermodul selbst beschrieben.

Jede Halbleiterbaugruppe weist hierbei ein erstes Leitungselement, mindestens ein hierauf angeordnetes Leistungshalbleiterbauelement sowie eine erste Kontakteinrichtung zur Kontaktierung des ersten Leitungselements und eine oder jeweils eine zweite Kontakteinrichtung zur Kontaktierung des Leistungshalbleiterbauelements auf. Das Leitungselement dient somit zur elektrischen Verbindung einer ersten Kontaktfläche des Leistungshalbleiterbauelements und mittels der ersten Kontakteinrichtung deren weiterer elektrischer Verbindung innerhalb des Leistungshalbleitermoduls. Die zweite Kontakteinrichtung ist mittelbar oder unmittelbar mit einer zweiten Kontaktfläche, angeordnet auf einer der ersten Kontaktfläche gegenüberliegenden Hauptfläche des Leistungshalbleiterbauelements, verbunden. Für einen mittelbaren Kontakt kann auf der Kontaktfläche, zwischen dieser und dem zweiten Kontaktelement, noch ein zusätzliches, vorzugsweise flächiges, Leitungselement vorgesehen sein.

Bei rechteckig ausgestalteten Leistungshalbleiterbauelementen ist es vorteilhaft die ersten und zweiten Verbindungseinrichtungen als einen L-förmigen Metallkörper auszubilden, der einen Fuß auf dem Leitungselement bzw. auf dem Leistungshalbleiterbauelement aufweist und dieser Fuß mittels drucksintertechnisch entsprechend elektrisch leitend verbunden ist.

Im Rahmen des erfindungsgemäßen Herstellungsverfahrens eines Leistungshalbleitermoduls bildet die Ausbildung von derartigen Halbleiterbaugruppen einen wesentlichen Verfahrensschritt. Hierbei ist es bevorzugt, wenn alle thermisch oder elektrisch besonders beanspruchten Verbindungen als Drucksinterverbindungen ausgebildet sind.

Die Halbleiterbaugruppen sind, oder werden im Rahmen des Herstellungsverfahrens, auf der Grundplatte angeordnet, wobei zwischen dieser und dem Leitungselement der jeweiligen Halbleiterbaugruppe eine gemeinsame oder je Halbleiterbaugruppe eine Isolationseinrichtung vorgesehen ist. Diese Isolationseinrichtung dient der elektrischen Isolation gegen die Grundplatte, die somit bei der Verwendung des Leistungshalbleitermoduls dauerhaft auf einem Grundpotential liegen kann.

Eine bevorzugt vorhandene Verbindung zwischen der Grundplatte und der ggf. jeweiligen Isolationseinrichtung, kann ebenso wie eine ebensolche der Isolationseinrichtung zur Halbleiterbaugruppe als Klebeverbindung ausgebildet sein.

Es kann alternativ oder zusätzlich bevorzugt sein, wenn das Grundmodul weiterhin ein Grundgehäuse aufweist, das rahmenartig ausgebildet ist und Positioniermittel zur Anordnung der Halbleiterbaugruppen oder Teilen hiervon aufweist. Derartige Positioniermittel können beispielhaft ausgebildet sein als Führungselement sowie als Rastnasen zur Steck-Rast-Verbindung der Halbleiterbaugruppen mit dem Grundgehäuse im Rahmen des Herstellungsverfahrens.

Das Verbindungsmodul weist seinerseits mindestens eine Verbindungseinrichtung auf. Diese mindestens eine Verbindungseinrichtung dient der schaltungsgerechten Verbindung, genauer der Last- nicht der Steuerverbindung, zweier Halbleiterbaugruppen. Hierbei werden abhängig von der zu realisierenden Schaltungsvarainte beispielhaft Verbindungen zwischen ersten oder zwischen zweiten Verbindungseinrichtungen zweier Halbleiterbaugruppen ausgebildet. Ebenso ist es möglich Verbindungen zwischen ersten und zweiten Verbindungseinrichtungen unterschiedlicher Halbleiterbaugruppen auszubilden.

Es ist hierbei bevorzugt, wenn das mindestens eine Verbindungselement als an jeweils einer von mehreren Sollbiegestellen verformter dreidimensionaler, flächiger Metallformkörper ausgebildet ist. Im Rahmen des Herstellungsverfahrens wird das ursprünglich noch nicht dreidimensional verformte Verbindungselement vorzugsweise mittels ein Schweißverbindungen mit den zugeordnetent Kontakteinrichtungen elektrich leitend verbunden. Im Anschluss daran wird durch schrittweises Abkanten an geeigneten Sollbiegestellen und die dreidimensionale Gestalt der Verbindungseinrichtung in dem Leistungshalbleitermodul ausgebildet.

Hierbei kann es bevorzugt sein in einem Zwischenschritt einen Deckel des Leistungshalbleitermoduls anzuordnen. Hierbei ist es besonders bevorzugt, wenn dieser Deckel zusammen mit dem Grundgehäuse das Gehäuse des Leistungshalbleitermoduls ausbildet.

Weiterhin kann es bevorzugt sein vor, nach oder gleichzeitig mit der Anordnung und Verbindung der mindestens einen Verbindungseinrichtung auch noch mindestens ein Verbindungsmittel anzuordnen und schaltungsgerecht mit einer zugeordneten Kontakteinrichtung zu verbinden.

Somit kann bei gleicher Ausgestaltung des Grundmoduls, nur durch ein geändertes Verbindungsmodul die interne Schaltungsvariante des Leistungshalbleitermoduls unterschiedlich ausgebildet werden.

Weiterhin bilden externe Kontaktelemente die externen Anschlusselemente des Leistungshalbleitermoduls ausbilden. Diese externen Kontaktelemente sind vorzugsweise als Schraubaufnahmen ausgebildet, können allerdings ebenso als Federkontakte, wie auch als federbelastete Steckverbindungen ausgebildet sein. Verbindungsmittel unterscheiden sich somit von Verbindungseinrichtungen dadurch, dass sie nur der Verbindung einer Kontakteinrichtung mit einem zugeordneten externen Kontaktelement dienen, während Verbindungseinrichtungen Halbleiterbaugruppen miteinander verbinden und bevorzugt zusätzlich mit einem externen Kontaktelement verbunden sind.

wobei mindestens zwei Elemente, die entweder Verbindungsmittel oder Verbindungseinrichtungen sind, bei Anordnung und schaltungsgerechter Verbindung zu den zugeordneten Kontakteinrichtungen miteinander mittels mindestens eines Verbindungssteges verbunden sind und dieser Verbindungssteg im Nachgang entfernt oder aufgetrennt wird.

Die erfinderische Lösung wird an Hand der Ausführungsbeispiele gemäß den Fig. 1 bis 3 weiter erläutert.

Fig. 1 zeigt schematisch ein erfindungsgemäßes Leistungshalbleitermodul in Explosionsdarstellung.

Fig. 2 zeigt schematisch das erfindungsgemäße Leistungshalbleiterbauelement gemäß Fig. 1 nach Abschluss des Herstellungsverfahrens.

Fig. 3 zeigt eine Draufsicht auf ein Grundmodul des Leistungshalbleitermoduls gemäß Fig. 1.

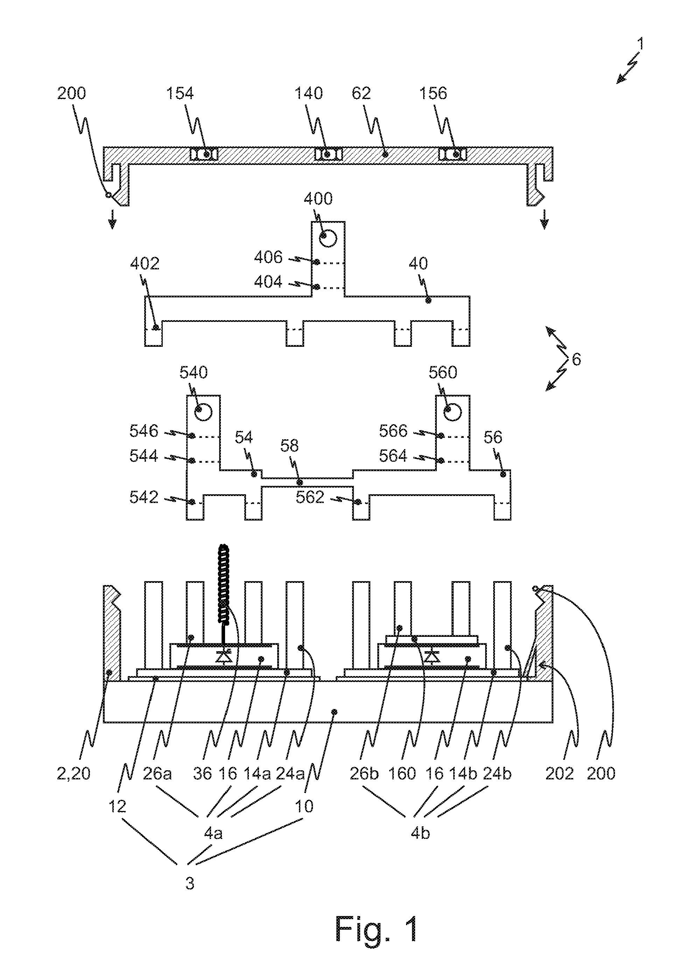

Fig. 1 zeigt schematisch ein erfindungsgemäßes Leistungshalbleitermodul (1) in Explosionsdarstellung und verdeutlich hierdurch auch das erfindungsgemäße Herstellungsverfahren. Dargestellt sind voneinander beabstandet ein Grundmodul (3) mit Grundgehäuse (20), ein Verbindungsmodul (6) und ein Deckel (62) diese Leistungshalbleitermoduls. Das Grundmodul (3) weist hier eine Grundplatte (10), üblicherweise aus einem sehr gut Wärme leitenden Metall, auf. Auf dieser Grundplatte (10) und dem Inneren des Leistungshalbleitermoduls (1) zugewandt sind hier zwei Isolationseinrichtungen (12) vorgesehen.

Auf diesen Isolationseinrichtungen (12) wiederum ist je eine Halbleiterbaugruppe (4 a/b) vorgesehen, die somit elektrisch isoliert von der Grundplatte (10) in dem Leistungshalbleitermodul (1) angeordnet ist. Die jeweilige Halbleiterbaugruppe (4 a/b) besteht aus einem Leitungselement (14 a/b), hier genau einem Leistungshalbleiterbauelement (16) und ersten und zweiten Kontakteinrichtungen (24 a/b, 26 a/b).

Das Leistungshalbleiterbauelement (16) bzw. dessen erste Kontaktfläche, genauer Lastkontaktfläche, ist vorzugsweise mittels einer Drucksinterverbindung mit dem ersten Leitungselement (14 a/b) verbunden, während dieses erste Leitungselement ebenfalls vorzugsweise mittels einer Drucksinterbindung mit der ersten Kontakteinrichtung (24 a/b) verbunden ist. Die zweite Kontaktfläche, ebenfalls eine Lastkontaktfläche, des Leistungshalbleiterbauelements (16) ist mit der zweiten Kontakteinrichtung (26 a/b), wiederum bevorzugt mittels einer Drucksinterverbindung, elektrisch leitend verbunden.

Speziell bei der Ausgestaltung des Leistungshalbleitermoduls (1) als Dioden- / Thyristormodul mit mittlerer Leistung ist es bevorzugt, wenn die Leistungshalbleiterbauelemente (16) eine rechteckige, plättchenartige Grundform aufweisen. Bei dieser Ausgestaltung ist es dann auch bevorzugt, wenn die ersten und zweiten Kontakteinrichtungen (24 a/b, 26 a/b) als L-förmige Metallkörper ausgebildet sind. Um die Stromtragfähigkeit sicher zu stellen oder zu erhöhen, kann die jeweilige Kontakteinrichtung (24 a/b, 26 a/b) eine Mehrzahl dieser L-förmigen Metallformkörper aufweisen.

Zusätzlich weist die erste Halbleiterbaugruppe (4a) ein Hilfsanschlusselement (36) in Form einer Kontaktfeder zur Kontaktierung des Steueranschlusses des Leistungshalbleiterbauelements (16), hier eines Thyristors, auf. Weiterhin weist das Leistungshalbleiterbauelement (16) der zweiten Halbleiterbaugruppe (4b) auf seiner der Grundplatte abgewandten Seite ein zweites Leitungselement (160) auf. Diese dient beispielhaft der mechanischen Entkopplung des Leistungshalbleiterbauelements (16), hier einer Diode, und der zugeordneten zweiten Kontakteinrichtung (26b). Selbstverständlich kann auch der Steueranschluss des Leistungshalbleiterbauelements (16) analog den Lastanschlüssen Metallkörper in Verbindung mit Verbindungsmitteln (54, 56) oder Verbindungseinrichtungen (40) ausgebildet sein.

Von dem Grundmodul (3) beabstandet dargestellt ist das Verbindungsmodul (6), das seinerseits eine Verbindungseinrichtung (40) und zwei Verbindungsmittel (54, 56) aufweist. Die beiden Verbindungsmittel (54, 56) sind hier zur Vereinfachung des Herstellungsverfahrens des Leistungshalbleitermoduls (1) mit einem Verbindungssteg (58) verbunden vorgesehen, der nach der der Verbindung mit den zugeordenten Kontakteinrichtungen (26a, 24b) vollständig entfernt wird. Es kann unter Beachtung der notwendigen Isolationsabstände auch ausreichend sein, den Verbindungssteg (58) nur zu durchtrennen. Derartige Verbindungsstege (58) können im Rahmen des Herstellungsprozesses grundsätzlich zur beliebig Verbindung von Verbindungsmitteln (54, 56) und / oder Verbindungseinrichtungen (40) vorgesehen sein.

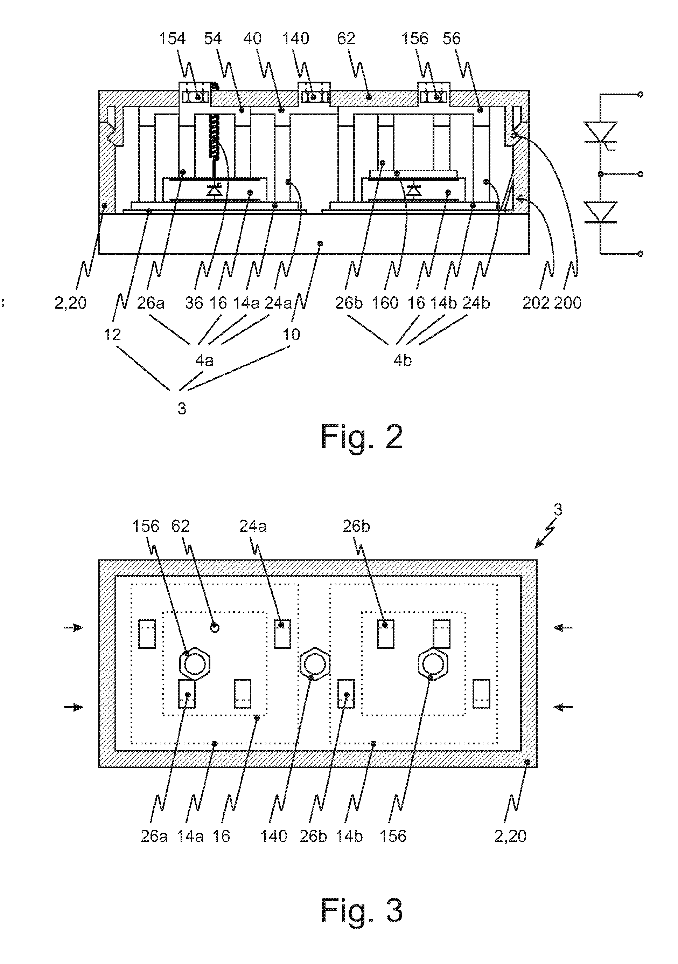

Die Verbindungseinrichtung (40), wie auch die Verbindungsmittel (54, 56) sind als flächige Metallformkörper ausgebildet, der Kontaktstellen zu den Kontakteirichtungen (24 a/b, 26 a/b) des Grundmoduls (3) aufweisen und somit eine von meist mehreren Schaltungsvarianten des Leistungshalbleitermoduls (1) ausbildet. Hierbei kann es, vgl. Fig. 3, möglicherweise zusätzlich notwendig sein eine der beiden Halbleiterbaugruppen (4 a/b) um 180 Grad verdreht vorzugsehen, um die Lage deren Kontakteinrichtungen (24 a/b, 26 a/b) im Sinne einer einfachen Verbindung zu verändern.

Weiterhin sind hier externe Kontaktelemente (140, 154, 156) als Teil des Verbindungsmoduls (6) vorgesehen, die der externen elektrischen Verbindung des Leistungshalbleitermoduls (1) dienen und hier in einem Kunststoffkörper dem Deckel (62) des Leistungshalbleitermoduls angeordnet sind. Diese externen Kontaktelemente (140, 154, 156) sind hier beispielhaft als Teil von Schraubverbindungen ausgebildet. Elektrisch stehen diese externen Kontaktelemente (140, 154, 156) in mittelbarem Kontakt mit den zugeordneten ersten und zweiten Kontakteinrichtungen (24 a/b, 26 a/b). Zur Ausbildung einer externen Schraubverbindung weist die Verbindungseinrichtung und die Verbindungsmittel entsprechende Ausnehmungen (400, 540, 560) auf.

In dieser Ausgestaltung des Leistungshalbleitermoduls (1) ist das elektrisch isolierende Gehäuse (2) ausgebildet durch ein Grundgehäuse (20) als weiterer Teil des Grundmoduls (3) und durch den Deckel (62). Besonders vorteilhaft ist es, wenn das Grundgehäuse (20) mit dem Deckel (62) mittel eine Schnapp- Rast- Verbindung (200) verbunden ist. Es kann allerdings neben weiteren möglichen Ausgestaltungen vorteilhaft sein eine Schraubverbindung zwischen Grundgehäuse (20) und Deckel (62) vorzusehen.

Weiterhin kann es vorteilhaft sein, wenn das Grundgehäuse (20) Positioniermittel (202) aufweist, um die Halbleiterbaugruppen (4 a/b) positionsgerecht anzuordnen und / oder auf der Grundplatte (10) zu fixieren.

Das erfindungsgemäße Herstellungsverfahren weist zusammengefasst somit die Schritte auf:
- Ausbilden der Halbleiterbaugruppen (4 a/b);
- Elektrisch isoliertes Anordnen der Halbleiterbaugruppen (4 a/b) zur Ausbildung des Grundmoduls (3) einschließlich des rahmenartigen Grundgehäuses (20),
- Anordnen und Verbinden der Verbindungsmittel (54, 56) und der Verbindungseinrichtung (40);
- Abkanten der Verbindungsmittel (54, 56) und der Verbindungseinrichtung (40) vorzugsweise nur an ersten und zweiten Sollbiegestellen (402, 404, 542, 544, 562, 564);
- Anordnen des Deckels (62) auf dem Grundgehäuse (20) unter Ausbildung des vollständigen Gehäuses (2);
- Abkanten der Verbindungsmittel (54, 56) und der Verbindungseinrichtung (40) vorzugsweise an dritten Sollbiegestellen (406, 546, 566).

Fig. 2 zeigt das Leistungshalbleitermodul (1) gemäß Fig. 1 nach Herstellung, wobei hier der Verbindungssteg (58) der beiden mechanisch miteinander verbunden Verbindungsmittel (54, 56) bereits entfernt ist und die Schnapp-Rast-Verbindung (200) zwischen Grundgehäuse (20) und Deckel (62) ausgebildet ist.

Weiterhin dargestellt ist die durch die Verbindungseinrichtung (40) realisierte Serienschaltung eines Thyristors und einer Diode. Die Mittelanzapfung dieser Schaltung wird in dem Leistungshalbleitermodul (1) ausgebildet durch das externe Kontaktelement (140), das mit der Verbindungseinrichtung (40) in elektrischem Kontakt steht.

Fig. 3 zeigt eine Draufsicht auf ein Grundmodul (3) des Leistungshalbleitermoduls (1) gemäß Fig. 1. Neben dem rahmenartigen Gehäuse (20) sind gestrichelt die Leitungselemente (14 a/b) und die Leistungshalbleiterbauelemente (16) dargestellt. Ebenso sind die ersten und zweiten Kontakteinrichtungen (24 a/b, 26 a/b) der jeweiligen Halbleiterbaugruppen (4 a/b) dargestellt. Diese Kontakteinrichtungen (24 a/b, 26 a/b) sind aus oben genannten Gründen hier als L-förmige Metallkörper ausgebildet. Ebenso sind die Position der Kontaktfeder (36) des Steueranschlusses des Leistungshalbleiterbauelements einer Halbleiterbaugruppe (4a), wie auch die externen Kontaktelemente (140, 154, 156), dargestellt.

Die oberen Pfeile zeigen die Position der mittels Verbindungssteg (58) gekoppelten Verbindungsmittel (54, 56), während die unteren Pfeile die Position der Verbindungseinrichtung (40) im zum Zeitpunkt deren Anordnung zeigen.

## Patentansprüche

1. Leistungshalbleitermodul (1) mit einem elektrisch isolierenden Gehäuse (2), einem Grundmodul (3) und einem Verbindungsmodul (6), wobei das Grundmodul (3) eine Grundplatte (10) und hierauf durch mindestens eine Isolationseinrichtung (12) elektrisch isoliert angeordnete Halbleiterbaugruppen (4) jeweils mit einem ersten Leitungselement (14 a/b) mindestens einem hierauf angeordneten Leistungshalbleiterbauelement (16) sowie einer ersten Kontakteinrichtung (24 a/b) zur Kontaktierung und in elektrisch leitendem Kontakt zu dem ersten Leitungselement (14 a/b) und einer zweiten Kontakteinrichtung (26 a/b) zur Kontaktierung und in elektrisch leitendem Kontakt zu dem mindestens einen Leistungshalbleiterbauelement (16), aufweist und wobei
das Verbindungsmodul (6) mindestens eine Verbindungseinrichtung (40) aufweist, wobei diese mindestens eine Verbindungseinrichtung (40) jeweils den elektrischen Kontakt zwischen einer Kontakteinrichtung (24a, 26a) einer Halbleiterbaugruppe (4a) mit einer Kontakteinrichtung (24b, 26b) einer weiteren Halbleiterbaugruppe (4b) ausbildet.

2. Leistungshalbleitermodul nach Anspruch 1, wobei
das Verbindungsmodul (6) mindestens ein weiteres Verbindungsmittel (54, 56) aufweist, das schaltungsgerecht, mit einer ersten (24 a/b) oder mit einer zweiten Kontakteinrichtung (26 a/b) verbunden ist.

3. Leistungshalbleitermodul nach Anspruch 1 oder 2, wobei
der mindestens einen Verbindungseinrichtung (40) und dem mindestens einen Verbindungsmittel (54, 56) jeweils ein externes Kontaktelement (140, 154, 156) zugeordnet und elektrisch leitend mit diesem verbunden ist.

4. Leistungshalbleitermodul nach Anspruch 1, wobei
das Grundmodul (3) selbst ein rahmenartiges elektrisch isolierendes Grundgehäuse (20) aufweist und dieses Grundgehäuse (20) Positioniermittel (202) für die Halbleiterbaugruppen (4 a/b) oder Teile hiervon aufweist.

5. Leistungshalbleitermodul nach Anspruch 1, wobei
das mindestens eine Verbindungselement (40) als an jeweils einer von mehreren Sollbiegestellen (402, 404, 406) verformter dreidimensionaler, flächiger Metallformkörper ausgebildet ist.

6. Verfahren zur Herstellung eines Leistungshalbleitermoduls (1) mit einem elektrisch isolierenden Gehäuse (2), einem Grundmodul (3) und einem Verbindungsmodul (6), **gekennzeichnet durch** die wesentlichen Verfahrensschritte
• Ausbilden von Halbleiterbaugruppen (4 a/b) jeweils mit einem ersten Leitungselement (14 a/b) mindestens einem hierauf angeordneten Leistungshalbleiterbauelement (16) sowie einer ersten Kontakteinrichtung (24 a/b) in elektrisch leitendem Kontakt zu dem ersten Leitungselement (14 a/b) und einer zweiten Kontakteinrichtung (26 a/b) in elektrisch leitendem Kontakt zu dem mindestens einen Leistungshalbleiterbauelement (16);
• Ausbilden des Grundmoduls (3) **durch** elektrisch isoliertes Anordnen, mittels mindestens einer Isolationseinrichtung (12), der Halbleiterbaugruppen (4 a/b) auf einer Grundplatte (10);
• Anordnen und schaltungsgerechtes Verbinden der mindestens einen Verbindungseinrichtung (40) des Verbindungsmoduls (6) mit zugeordneten Kontakteinrichtungen (24b, 26a) der Halbleiterbaugruppen (4 a/b);

7. Verfahren gemäß Anspruch 6, wobei
die schaltungsgerechte Verbindung zwischen der mindestens einen Verbindungseinrichtung (40) und den zugeordneten Kontakteinrichtungen (24b, 26a) mittels Schweißverbindungen hergestellt wird.

8. Verfahren gemäß Anspruch 7, wobei
nach Anordnen und schaltungsgerechtem Verbinden der Verbindungseinrichtung (40) mit zugeordneten Kontakteinrichtungen (24b, 26a) diese als ein flächiger Metallformkörper ausgebildete Verbindungseinrichtung (40) durch schrittweises Abkanten an geeigneten Sollbiegestellen (402, 404, 406) und damit dreidimensional in dem Leistungshalbleitermodul angeordnet wird.

9. Verfahren gemäß Anspruch 6, wobei
neben der Anordnung der mindestens einen Verbindungseinrichtung (40) noch mindestens ein Verbindungsmittel (54, 56) angeordnet und schaltungsgerecht mit einer zugeordneten Kontakteinrichtung (24a, 26b) verbunden wird.

10. Verfahren gemäß Anspruch 6 oder 9, wobei
wobei mindestens zwei Elemente, die entweder Verbindungsmittel (54, 56) oder Verbindungseinrichtungen (40) sind, bei Anordnung und schaltungsgerechter Verbindung zu den zugeordneten Kontakteinrichtungen (24 a/b, 26 a/b) miteinander mittels mindestens eines Verbindungssteges (58) verbunden sind und dieser Verbindungssteg (58) im Nachgang entfernt oder durchtrennt wird.

11. Verfahren gemäß Anspruch 6, wobei
mindestens eine elektrisch leitenden Verbindung, bevorzugt aber alle elektrisch leitenden Verbindungen innerhalb der Halbleiterbaugruppen (4 a/b) als Drucksinterverbindungen ausgebildet werden.
